# Europäisches Patentamt

# European Patent Office

# Office européen des brevets

(19)

(11) Publication number: **0 052 892**

**B2**

(12)

# NEW EUROPEAN PATENT SPECIFICATION

(45) Date of publication of the new patent specification: **31.05.89**

(51) Int. Cl.⁴: **G 02 B 26/10**

(21) Application number: **81109933.2**

(22) Date of filing: **26.11.81**

(54) **Laser beam scanning system.**

(30) Priority: **26.11.80 JP 168357/80**

(43) Date of publication of application:
**02.06.82 Bulletin 82/22**

(45) Publication of the grant of the patent:
**07.05.86 Bulletin 86/19**

(45) Mention of the opposition decision:
**31.05.89 Bulletin 89/22**

(84) Designated Contracting States:
**DE FR GB NL**

(56) References cited:
**DE-A-2 127 943**
**GB-A-2 009 558**
**US-A-3 935 566**
**US-A-4 000 493**

**Acta histochemica, Suppl. Band XXI, p. 147-154**
**(1980)**

(73) Proprietor: **Hitachi, Ltd., 5-1, Marunouchi 1-chome, Chiyoda- ku Tokyo 100 (JP)**

(72) Inventor: **Hosaka, Sumio, 1-47- 1-D404, Akatsuki-cho, Hachioji- shi Tokyo (JP)**
Inventor: **Harada, Tatsuo, 2-59- 22, Shinmachi, Fuchu- shi Tokyo (JP)**
Inventor: **Takanashi, Akihiro, 1-28- 32, Fujimoto, Kakubunji- shi Tokyo (JP)**

(74) Representative: **Strehl, Peter, Dipl.- Ing., Patentanwälte Strehl Schübel- Hopf Groening Schulz Maximilianstrasse 54 Postfach 22 14 55, D-8000 München 22 (DE)**

## Description

The present invention relates to a laser beam pattern generator.

Some of the laser beam scanning systems according to the prior art make use of a polygon mirror or an apparatus for effecting a mechanical reciprocation of an objective lens. In the former scanning system using the polygon mirror, a biaxial scanning operation is performed by effecting both one scanning operation over a large field in a wide angle range in one direction with a lens having a large F-θ value and another scanning operation at a right angle wherein the specimen to be scanned is driven in a continuous mode or in a step-and-repeat mode with the use of a carriage. In this case, the scanning speed is high, but the diameter of the focussed laser beam spot is so large as to raise problems in scanning accuracy and resolution. In the latter scanning system on the other hand, the scanning operation over a large field is performed by effecting the reciprocating mechanical motions of the objective lens in a plane parallel with the specimen surface. In this case, since the system can use an objective lens having a high numerical aperture (N.A.), the laser probe diameter is so small as to provide excellent resolution, but there arise problems with the scanning speed and accuracy because of the mechanical motions.

The DE-A-2 127 943 discloses an information recording system using an acousto-optical cell to defect a laser beam in predetermined directions. The acousto-optical cell is driven by signals corresponding to the information to be recorded, each signal including a number of discrete frequency components. Due to these signals, the laser beam passing through the acousto-optical cell is splitted into a number of beam components, wherein each of these components corresponds to one of the frequency components and is deflected with a specific angle. In dependence on the respective defection angles, the beam components impinge upon fixed data positions on a recording medium which is provided on a rotating drum. Since the predetermined data positions correspond to binary values, this system enables to transform the information signals applied to the acousto-optical cell in binary data words and to record these data words line-by-line on the recording medium.

A further apparatus for recording stored information on a photo-sensitive medium with a laser beam is known from the U-A-4 000 493. Also in this apparatus, frequency signals corresponding to the information to be recorded control an acousto-optical cell. Thus, the laser beam passing through this acousto-optical cell is deflected in accordance with these signals.

A laser scanning microscope for analysing cells is described in Acta Histochemica, Suppl. Band XXI, pages 147 to 154 (1980). The known microscope shows a similar optical configuration as the present pattern generator, differing however in that a galvanometric mirror is used for scanning in a first direction, the second direction being scanned by moving the microscope carriage, thus providing a large enough field to scan a specimen.

The use of acousto-optical means for scanning is contemplated but no indication of how to increase the small scanning field resulting from such scanning means is given.

According to the identical functional principles as disclosed in the above-mentioned references, the information to be stored on the recording medium is defined by the value of the defection of the incident beam.

The object underlying the present invention is to provide a laser beam scanning system for scanning at high speed and high accuracy a wide area of a specimen surface with a finely focused and intensity modulated laser beam in order to generate on the specimen surface with high positional resolution a pattern dependent on the modulation degree of the laser beam, i.e. for example a resist-latent image, an electrostatic-latent image or a machined pattern.

This object is solved by a laser beam pattern generator according to claim 1. Thus, according to the present invention, the pattern to be generated on the specimen surface is defined by the modulation degree of the incident beam, whereas the beam is deflected continuously over the entire specimen surface.

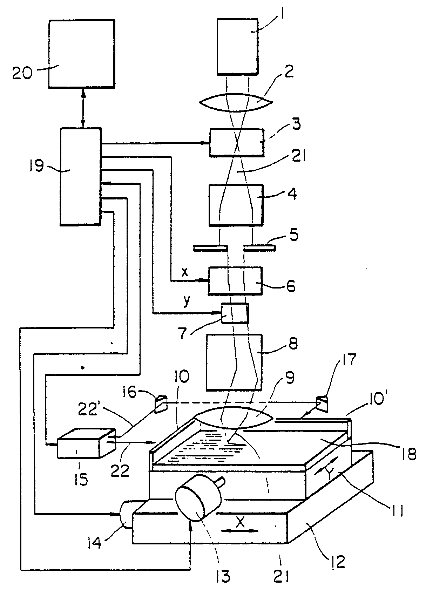

A preferred embodiment of the present invention will be described in connection with the attached Figure which is a schematic diagram showing the general construction of a laser beam scanning system according to one embodiment of the present invention.

At first, the basic concept of the present invention will be described.

The present invention is featured mainly by the fact that the following three points are organically combined so as to enable the scanning of a large field at high speed and high accuracy with a laser beam focused to a fine spot diameter.

Firstly, an acousto-optical deflecting element is used in the present invention in place of a defection system which employs a polygon mirror or a reciprocation mechanism used in the prior art. Generally, the laser beam, after it has been deflected by the deflector, is condensed for use by the objective lens. The spot diameter $D_g$ of the laser beam, after it has been focused by the objective lens, is expressed by the following equation (1), if the intensity of said laser beam is a Gaussian distribution:

$$D_g = \frac{2\lambda f}{\pi \omega_o} \tag{1}$$

In equation (1): $\lambda$ stands for the wavelength of the laser beam; f stands for the focal length of the objective lens; and $\omega_o$ stands for the beam diameter of the laser beam incident upon the objective lens.

On the other hand, the deflection $L_d$ for a

deflection angle θ is expressed by the following equation (2):

$$L_d = f \tan \theta \qquad (2)$$

In order to focus the spot diameter $D_g$ of the laser beam to a fine diameter around the size of the laser wavelength and to enlarge the defection $L_d$, it would be necessary from equations (1) and (2) that the beam diameter $\omega_o$ incident upon the objective lens and the focal length f of said objective lens are enlarged simultaneously. It is, however, difficult to realize an objective lens which can satisfy such specifications, thus raising a limit of itself. In order to maintain a fine spot diameter $D_g$ of the laser beam having the dimension of the laser wavelength, more specifically, it is found necessary from equation (1) that the focal length f is made small. Consequently the deflection $L_d$ of equation (2) will have a small value. For this reason, it is advantageous that an acousto-optical deflecting element having a far higher defection frequency and controllability than the polygon mirror is used as the deflector.

Secondly, in order to focus the spot diameter $D_g$ to a fine diameter around the laser wavelength dimension, as expressed by equation (1), it is necessary that the diameter $\omega_o$ of the laser beam incident upon the objective lens has a large value to fully use the available diameter of the objective lens. In the present invention, therefore, there is interposed between the aforementioned acousto-optical deflector and the objective lens a relay lens which projects the laser beam emerging from the deflector toward the center of the objective lens thereby enlarging the diameter of the laser beam. These objects can be achieved by an astronomical type telescopic system.

Thirdly, since the defection by the acousto-optical deflecting element covers a small field, as has been described hereinbefore, a sample carriage which can carry the specimen to be scanned at high speed and high accuracy in biaxial directions is used in combination with the abovementioned elements so as to enable a defection over a large field. Since the three technical means thus far described are each well known in the art, their detailed explanations are omitted here.

The present invention will now be described in more detail in connection with one embodiment thereof with reference to the accompanying drawing which shows the general construction in case the laser beam scanning system of the present invention is applied to a pattern generator. A laser beam 21 generated from a laser source 1 for the latent image forming or laser machining purpose is focussed upon the center of an optical modulator 3 by a condensing lens 2. After the modulation, the laser beam 21 is again collimated by a condenser lens 4 to a collimated beam which is deflected in the directions of two axes X and Y after passing through an aperture 5 by the actions of X- and Y-axes acousto-optical deflectors 6 and 7. These acousto-optical deflectors are made of $TeO_2$, $NiNbO_3$, $PbMoO_4$ or the like. The laser beam having passed through the deflectors 6 and 7 has its optical path so bent by a relay lens 8 as to have the deflection point projected toward the center of an objective lens 9 and has its beam diameter magnified by the relay lens 8 until it is focussed as a fine beam spot upon the upper surface of a specimen 18 by the objective lens 9. The beam spot thus made having a fine diameter is deflected to scan a small field of the specimen surface at high speed and high accuracy. The drawing shows the behavior in case a raster scanning operation is performed by continuously driving the specimen carriage. More specifically, the laser beam is finely deflected in the X-axis direction so that a band-shaped field on the specimen surface which is narrow in the X-axis direction is scanned by the aforementioned beam spot by virtue of the specimen carriage being continuously driven in the Y-axis direction by a Y-axis moving motor 13. Said band-shaped field is sequentially moved by driving the specimen at intervals in the X-axis direction by the action of an X-axis moving motor 14 so that a wide area on the specimen surface is completely scanned with the laser beam 21.

A laser measurement equipment 15 irradiates measuring mirrors 10 and 10', which are carried on a Y-axis moving table 11, with laser beams 22 and 22' to precisely measure the position of the carriage while the specimen is being moved thereby in order to feed a signal corresponding to a deviation from a destination address to a controller 19 so that said deviation is compensated by compensating the input signals to the acousto-optical deflectors 6 and 7. Thereby the scanning operations are performed at high speed and high accuracy. On the other hand, desired pattern data are stored in the memory of a computer 20 so that on the basis of those pattern data, the optical modulator 3 is operated by the controller 19 in correspondence with the deflected position of the laser beam spot whereby a desired resist latent image, electrostatic latent image, machined pattern or the like is formed on the specimen surface. In the drawing, numeral 12 indicates an X-axis moving table, and numerals 16 and 17 indicate reflectors, prisms or other means for changing the measuring laser beam path.

The embodiment of the scanning system thus far described is directed to the case in which the raster scanning system resorting to a continuous drive of the carriage in the direction of the axis Y is adopted. The present invention can be applied even to the case in which raster scanning and random access scanning systems using a step-and-repeat drive of the carriage are adopted.

As has been described hereinbefore, the present invention can facilitate the application of the laser beam to semiconductor lithographic technologies which require high speed and accuracy defection. Moreover, the present invention can provide various advantages including the one that the deflecting speed is increased by about one order over the prior art so that the time period required for the pattern formation can be shortened while maintaining the high accuracy.

## Claims

1. A laser beam pattern generator for scanning the surface of a specimen (18) with a finely focused and intensity modulated laser beam (21) comprising:
   - a laser light source (1) for generating a laser beam,
   - an optical modulator (3) for modulating said laser beam,
   - an acousto-optical deflector (6, 7) for scanning said laser beam (21) within a small field on the specimen surface,
   - a relay lens (8) for increasing the diameter of the laser beam (21) emerging from said acousto-optical deflector and thereby projecting said laser beam deflection point toward the centre of an objective lens (9),
   - an objective lens (9) for focusing the laser beam (21) to a spot upon the surface of said specimen (18),
   said elements being arranged in the above order in the optical path of the laser beam (21),
   - a specimen carriage (11, 12) for moving the specimen (18) in the directions of two axes (X, Y) in a plane parallel to the specimen surface within a field which is large compared to the field covered by the acousto-optical deflector (6, 7),
   - a position detector (10, 15) for detecting the position of the specimen carriage (11, 12), and
   - control means (19, 20) for correcting the input signal to the acousto-optical deflector (6, 7) in response to the output signal of said position detector (10, 15).

2. The laser beam pattern generator of claim 1, wherein said acousto-optical deflector (6, 7) is adapted to deflect the incident laser beam (21) in the direction of one axis.

3. The laser beam pattern generator of claim 1, wherein said acousto-optical deflector (6, 7) is adapted to deflect the incident laser beam (21) in the direction of two axes.

## Patentansprüche

1. Laserstrahl-Mustergenerator zum Abtasten der Oberfläche einer Probe (18) mit einem fein fokussierten und intensitätsmodulierten Laserstrahl (21) mit:
   - einer Laser-Lichtquelle (1) zum Erzeugen eines Laserstrahls,
   - einem optischen Modulator (3) zum Modulieren des Laserstrahls,
   - einer akusto-optischen Ablenkeinrichtung (6, 7) für eine Laserstrahl-Abtastung innerhalb eines kleinen Feldes auf der Probenoberfläche,
   - einer Relais-Linse (8), um den Durchmesser des aus der akusto-optischen Ablenkeinrichtung austretenden Laserstrahls (21) zu vergrößern und dadurch den Laserstrahl-Ablenkpunkt in Richtung auf das Zentrum einer Objektivlinse (9) zu projizieren,
   - einer Objektivlinse (9) zum Fokussieren des Laserstrahls (21) auf einen Fleck auf der Oberfläche der Probe (18),
   wobei die genannten Elemente in der obigen Reihenfolge im optischen Weg des Laserstrahls (21) angeordnet sind,
   - einem Probenträger (11, 12) zum Bewegen der Probe (18) in Richtung von zwei Achsen (X, Y) in einer Ebene parallel zur Probenoberfläche innerhalb eines Feldes, das im Vergleich zu dem durch die akusto-optische Ablenkeinrichtung (6, 7) abgedeckten Feld groß ist,
   - einem Positionsdetektor (10, 15) zum Erfassen der Position des Probenträgers (11, 12) und
   - einer Steuereinrichtung (19, 20) zum Korrigieren des Eingangssignals zu der akusto-optischen Ablenkeinrichtung (6, 7) in Antwort auf das Ausgangssignal des Positionsdetektors (10, 15).

2. Laserstrahl-Mustergenerator nach Anspruch 1, wobei die akusto-optische Ablenkeinrichtung (6, 7) für die Ablenkung des einfallenden Laserstrahls (21) in Richtung einer Achse ausgelegt ist.

3. Laserstrahl-Mustergenerator nach Anspruch 1, wobei die akusto-optische Ablenkeinrichtung (6, 7) für die Ablenkung des einfallenden Laserstrahls (21) in Richtung der zwei Achsen ausgelegt ist.

## Revendications

1. Générateur de tracés à faisceau laser servant à explorer par balayage la surface d'un échantillon (18) au moyen d'un faisceau laser (21) finement focalisé et à intensité modulée, comprenant:
   - une source de lumière laser (1) servant à produire un faisceau laser,
   - un modulateur optique (3) servant à moduler ledit faisceau laser,
   - un déflecteur acousto-optique (6, 7) servant à amener ledit faisceau laser (21) à exécuter un balayage dans une petite zone de la surface de l'échantillon,
   - une lentille relais (8) servant à accroître le diamètre du faisceau laser (21) sortant dudit déflecteur acousto-optique et projetant de ce fait ledit point de déviation du faisceau laser en direction du centre d'une lentille d'objectif (9),
   - une lentille d'objectif (9) servant à focaliser le faisceau laser (21) en un spot sur la surface dudit échantillon (18), lesdits éléments étant agencés dans cet ordre sur le trajet optique du faisceau laser (21),

- un chariot porte-échantillon (11, 12) servant à déplacer l'échantillon (18) dans les directions de deux axes (X, Y) dans un plan parallèle à la surface de l'échantillon dans une zone, qui est large par rapport à la zone couverte par le déflecteur acousto-optique (6, 7),

- un detecteur de position (10, 15) servant à détecter la position du chariot porte-échantillon (11, 12), et

- des moyens de commande (19, 20) servant à corriger le signal d'entrée envoyé au déflecteur acousto-optique (6, 7) en reponse au signal de sortie dudit détecteur de position (10, 15).

2. Générateur de tracés à faisceau laser selon la revendication 1, dans lequel ledit dispositif déflecteur acousto-optique (6, 7) est apte à dévier le faisceau laser incident (21) suivant la direction d'un axe.

3. Générateur de tracés à faisceau laser selon la revendication 1, dans lequel ledit dispositif déflecteur acousto-optique (6, 7) est apte à dévier le faisceau laser incident (21) suivant les directions des deux axes.